# EUROPEAN PATENT SPECIFICATION

(11) **EP 2 569 679 B1**
(45) Date of publication and mention of the grant of the patent: **31.10.2018**
(21) Application number: 11720577.3
(22) Date of filing: 11.05.2011
(51) Int. Cl.: G06F 1/16

(54) **a computing device comprising a clamshell design**
eine Computervorrichting mit einer aufklappbaren Ausführungsform
un dispositif informatique avec un design à double coque

(30) Priority: 11.05.2010 GB 201009952
(43) Date of publication of application: 20.03.2013
(73) Proprietor: Dell Products L.P., Round Rock, TX 78682-2244 (US)
(72) Inventor: BROGAN, Hugh, Douglas, Isle of Man IM99 2QW (GB); HINES, George, Berkhamsted HP4 3JQ (GB)
(74) Representative: Wegner, Hans
(86) International application number: PCT/GB2011/050908
(87) International publication number: WO 2011/141743

(56) References cited:
- KR-A- 20070 017 889
- US-A- 5 278 730
- US-B1- 6 359 777
- Anonymous: "MacBook Pro 13" Unibody Mid 2009 Teardown - iFixit", , 9 June 2009 (2009-06-09), XP055465204, Retrieved from the Internet: URL:https://www.ifixit.com/Teardown/MacBoo k+Pro+13-Inch+Unibody+Mid+2009+Teardown/81 4 [retrieved on 2018-04-06]

## Description

### BACKGROUND OF THE INVENTION

### 1. Field of the Invention

This invention relates to the design, subsystems and components together comprising a flexible architecture for computing devices which enables realisation of a plurality of different computing device models, sizes and form factors using common or similar subsystems, layout schemes, components, and/or designs thereof. The invention further enables common or similar manufacturing; assembly and test methods; processes; and/or apparatuses.

The invention may be applicable to many types of computing devices, which may include but are not limited to laptop/notebook computers, netbook computers, tablet computers, convertible (dual notebook-style and tablet-style) computers, and/or all-in-one (where the display and computing engine are combined in a single unit) or desktop computers. The invention may be further applicable to certain form factors of mobile telephones, portable media players, satellite navigation devices, or similar devices.

The invention addresses common problems arising in the design and manufacture of such computing devices, especially portable computing devices, which include restrictions on size, thickness and weight; heat dissipation; time to market reduction; quality and reliability; and logistical and manufacturing complexity.

### 2. Description of the Prior Art

Several computing device trends have exposed the limitations of commonly employed methods of device design and manufacture:
- Vendors are expected to field an ever wider variety of device types and models, and to get those devices to market more quickly than in the past.
- Smaller size and weight-and especially thinness-are becoming prerequisites at most product price tiers as opposed to just as the highest design or luxury tiers.
- Consumers are rejecting negative performance impacts in order to achieve smaller size and weight goals.
- Battery performance improvements have been outpaced by processor, display and other components' power requirements and miniaturization, resulting in batteries accounting for an ever greater proportion of overall system size.
- As processor speed and performance increase, thermal solutions to assist with heat dissipation have an ever greater impact on the overall system design.
- The competitive imperative to offer devices with ever more additional capabilities, such as sensors, cameras, touchscreens, media readers, multimedia connectors, and peripheral connectors increases design and manufacturing complexity, and puts further pressure on size and weight goals.
- As new form factors, such as tablets and convertible computers, have emerged, existing design paradigms struggle to adapt.
- Vendors are more likely than ever to outsource, often to multiple suppliers in parallel, various aspects of computing device design, manufacturing and distribution.

While they may look similar externally and may share some components, different models and sizes of computing device today are generally designed with little or no internal similarity, and wholly or largely new designs are necessary when vendors wish to introduce new model types or sizes.

The lack of commonality among computing device designs extends to major components and subsystems. For example, it is not uncommon for a major computing device vendor to have dozens of different laptop battery part numbers across their ranges. For example, the Acer UK website listed 35 current laptop batteries when checked, while the HP US website listed 24.

Even in the cases where battery cells themselves are shared across a number of laptop models, the complete battery subassemblies are often different due to such factors as structural elements, cosmetic elements or differently placed connectors.

Efforts to reduce device thinness in a cost effective and scalable manner have proven especially lacking. Laptop models such as the Apple Macbook Air and the Dell Adamo are essentially "one off" designs that are both expensive and difficult to manufacture. With the MacBook Air especially, the designers have achieved thinness in part by exclusion of commonly expected device capabilities.

Deficiencies are also apparent in current attempts to minimize thickness in other form factors, such as tablets. For example, the Apple iPad and iPad 2 are widely criticized for omitting industry standard USB ports.

The patent US 5 278 730 discloses a modular notebook computer which has a framework with module bays for receiving CPU modules, power modules, and peripheral function modules, such as floppy and hard disk drives. The framework has a built-in compressed bus and a variety of function modules which can be plugged into any one of the module bays. Function modules include, but are not limited to, CPU, power, floppy disk, hard disk, RAM memory, LAN communication, modem, FAX communication, and data acquisition.

The patent US 6 359 777 B1 discloses a computer housing that has a number of compartments for inserting or removing computer components. When a wearable computer is used, weight is extremely important. This invention allows the user to keep only the computer components he or she needs and easily remove the components that are not essential or needed.

The patent application KR 2007 0017889 A discloses a mobile phone that has a clamshell design, where the display part closes behind and flush with an end part of the main housing.

### SUMMARY OF THE INVENTION

The invention concerns a computing device comprising a clamshell design, as defined in the appended claims.

### BRIEF DESCRIPTION OF THE DRAWINGS

The invention will be described with reference to the following drawings:
- Figure 1: Generic Portable Computing Device - Detail
- Figure 2: Possible Concept Architecture - Base Assembly (1)
- Figure 3: Possible Concept Architecture - Base Assembly (2)
- Figure 4: Possible Concept Architecture - Display assembly (1)
- Figure 5: Possible Concept Architecture - Display assembly (2)
- Figure 6: Possible Concept Architecture - Convertible Computer Alternative
- Figure 7: Flush Design vs Stack Design - Closed View
- Figure 8: Concept Scalability Example - Flush Design
- Figure 9: Concept Scalability Example - Stack Design
- Figure 10: Possible Internal Component Layout (1)
- Figure 11: Possible Internal Component Layout (2)

### DETAILED DESCRIPTION

The invention is described with reference to the included drawings.

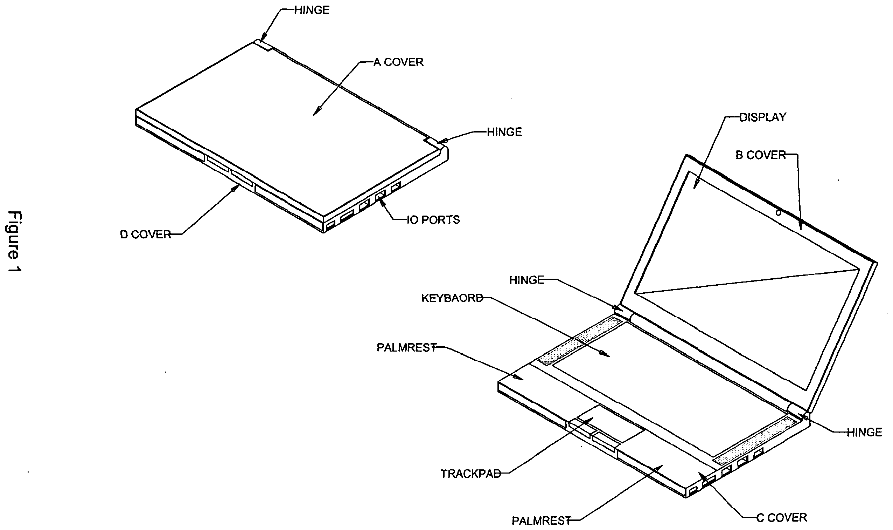

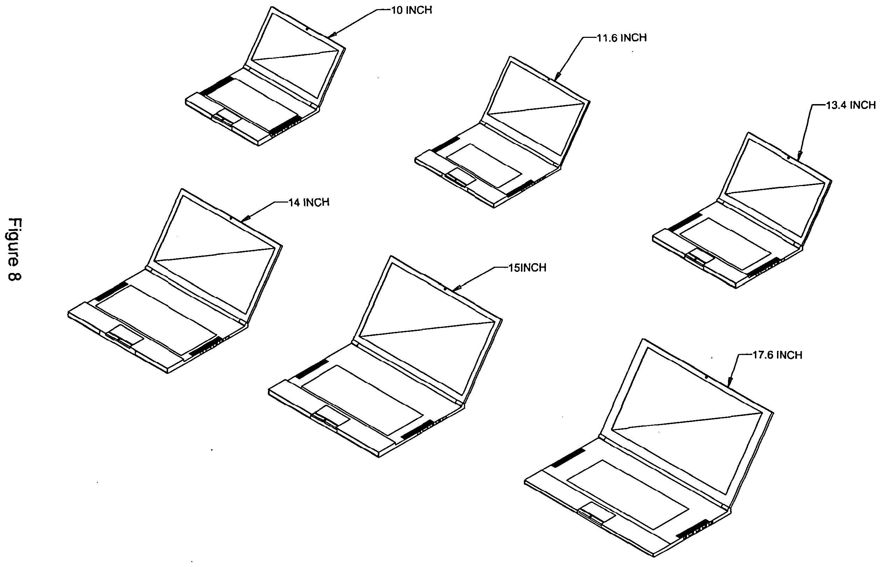

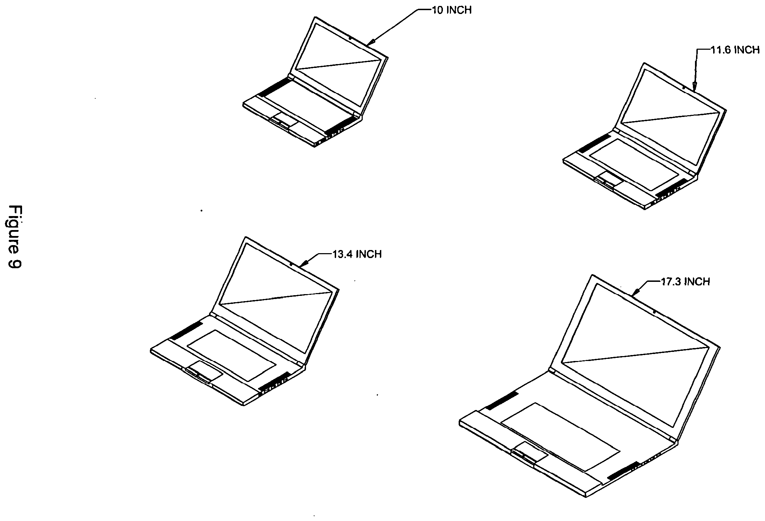

Figure 1 shows commonly used terms, which will be used throughout, for some parts of a typical laptop-style computing device. Illustrated and related terms are:
- A Cover - The large top surface of the laptop clamshell when closed. The A Cover may include the wordmark or logo of the vendor
- B Cover - The upper inside surface of the laptop clamshell when open. The B Cover typically surrounds the main display panel.
- C Cover - The lower inside surface of the laptop clamshell when open. The C Cover typically surrounds the keyboard and (In the stack design) or other pointing device.
- D Cover - The large bottom surface of the laptop clamshell when closed. The D Cover is often features a registration plate and typically also has removable access panels for various components.
- Front, back or side panels (not shown separately) - Front back and side cosmetic and or structural panels on the upper or base sections of the laptop clamshell may be incorporated into one or more of the four main panels or may be separate parts.
- Display, keyboard and trackpad (shown); and camera, microphone, speakers, etc. (not shown) - User interface elements, generally exposed through a cover.
   ∘ Portable computing device are often grouped by similar display size, typically measured diagonally in inches across the screen. See Figure 8 and Figure 9 for examples of various screen sizes.
- Palmrests - Areas on which to rest the hands while typing, typically between the front edge of the device and keyboard, incorporated into the C Cover on the stack design and in the A prime cover on the flush design and often separated by a trackpad or other pointing device.
- Hinge(s) - A hinge or hinges typically connect the upper/display part of the clamshell with lower/keyboard part of the clamshell. Hinges may be bidirectional or multidirectional and may take a variety of forms. Hinges also typically include provision for a cable or cable for connections among components in the upper and lower parts of the clamshell.
- I/O ports - Any of the many possible connecter ports typically found on a computing device, such as USB ports, display ports of various standards, power connectors and other ports. They may be located on any surface but are typically found in the base rear or side panels. It is best practice to locate the I/O ports as close as possible to the computing engine in order to minimize the potential for electromagnetic interference. However, they may also be located away from the computing engine as shown in some of the included drawings.

Although the description given and figures shown reference primarily a laptop-style form factor device, all relevant parts of the invention are also applicable to other form factors. Certain elements may not be present in all form factors. For example, a typical tablet-style computing device will not have hinges, although an otherwise similar typical convertible device often would.

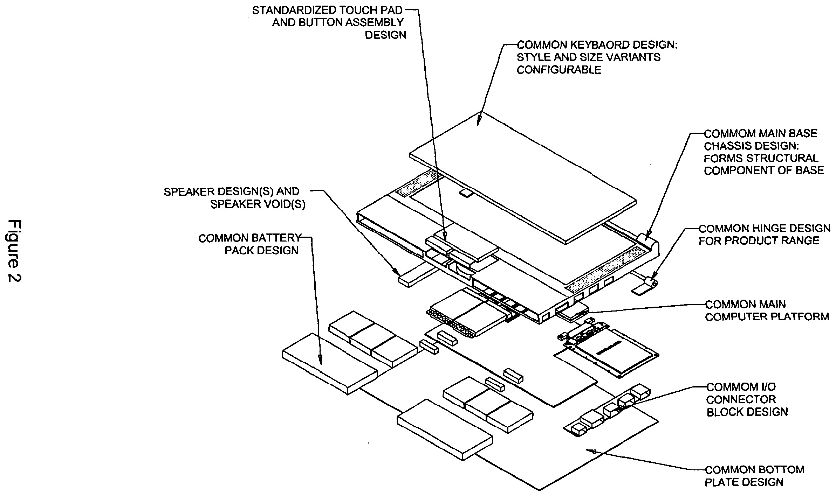

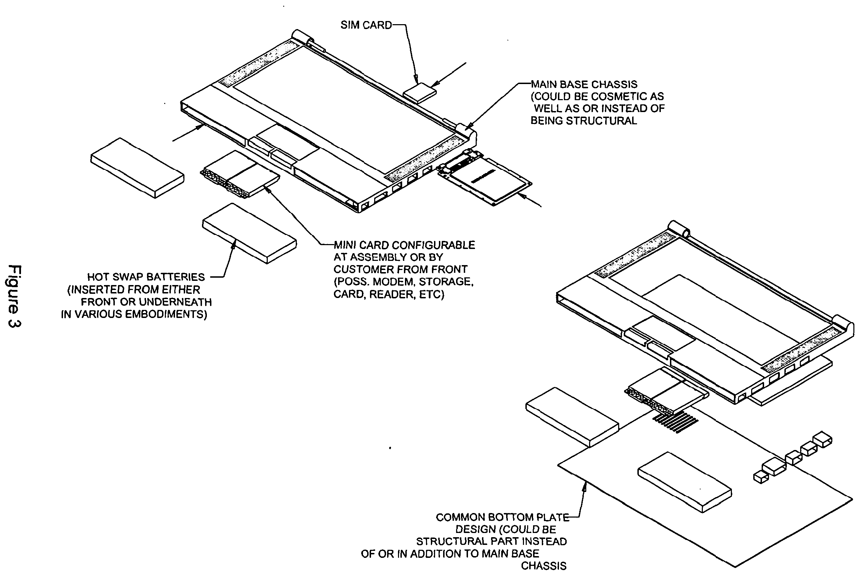

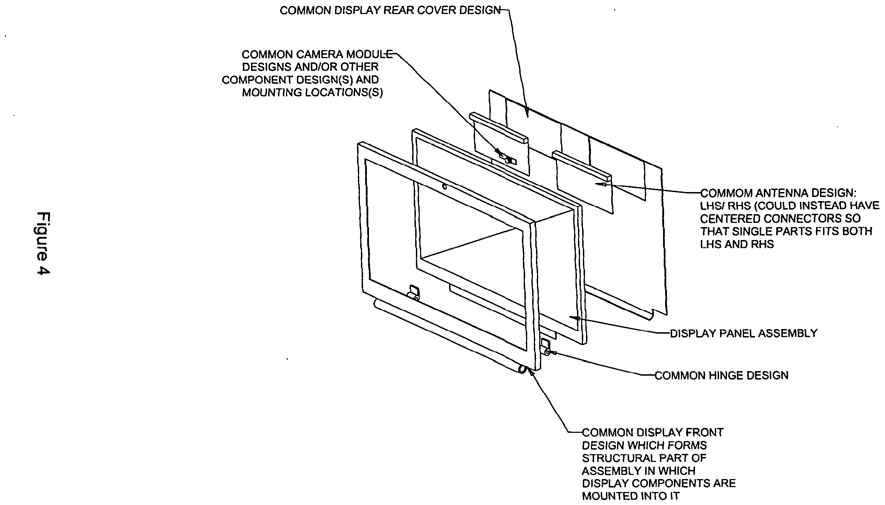

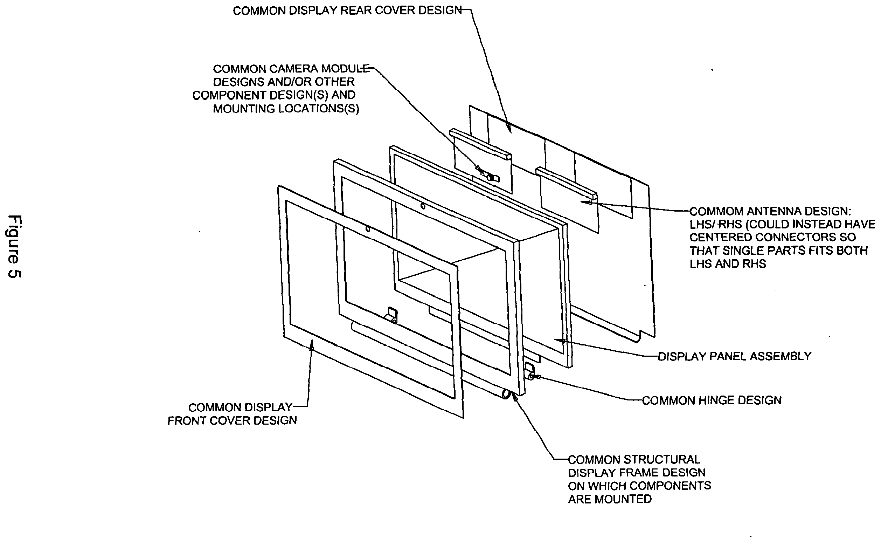

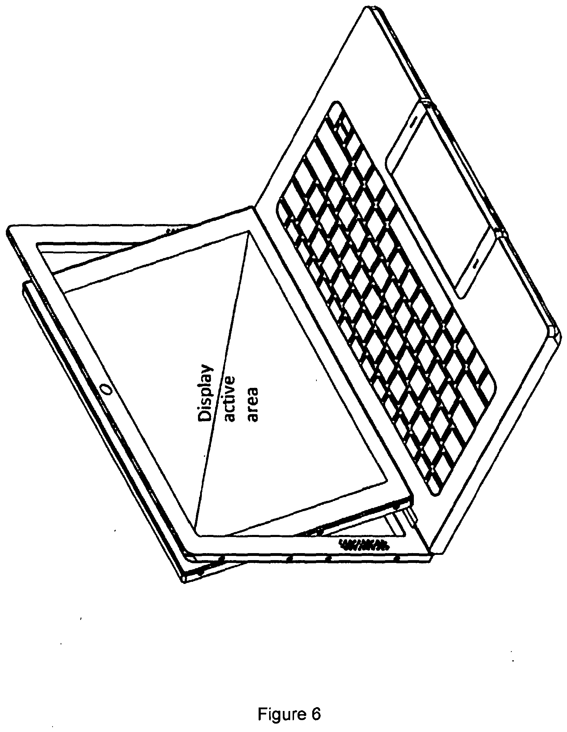

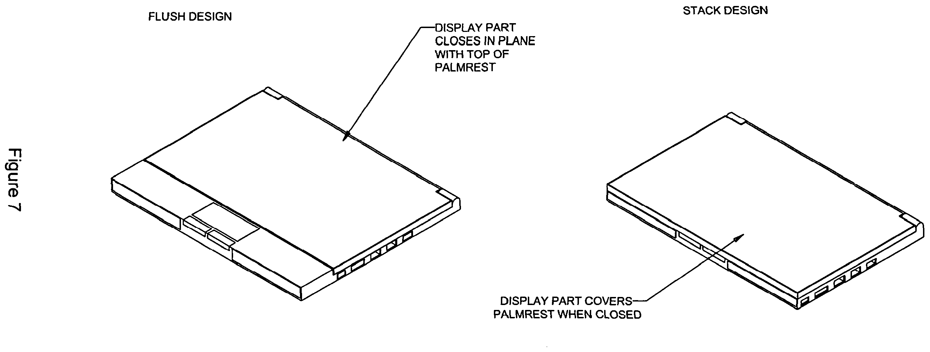

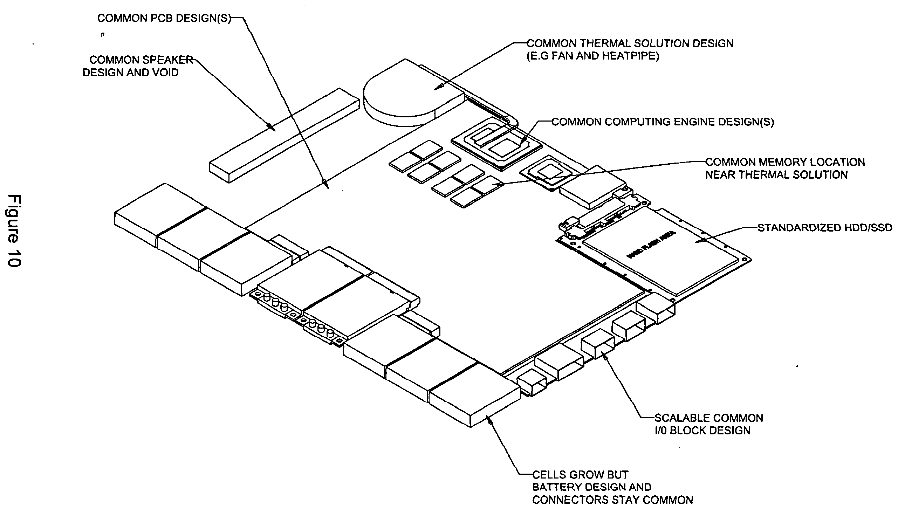

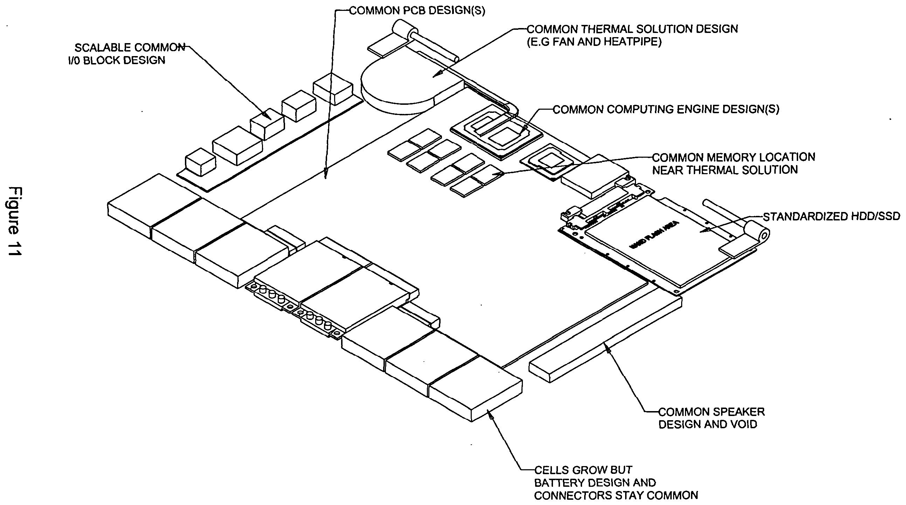

The invention is a computing device architecture comprising:
1. Main Base Chassis (See Figure 2 and Figure 3) - A (figuratively) flexible and scalable internal and/or external substructure or chassis that is common or similar among a plurality of device models, sizes and form factors. The Main Base Chassis may:
   a. Provide rigidity to the computing device base and resist/absorb torsional or other forces
   b. Provide a frame on which other cosmetic or functional mechanical elements, e.g., the C Cover and D Cover, may be mounted. It may also incorporate some of those cosmetic or functional elements, such as serving as the C Cover and/or a D Cover, or the A and B cover in a tablet design.
   c. Provide a frame on or into which electronic and electromechanical parts or components, e.g., I/O ports and motherboard, may be mounted and/or protected
   d. Determine the placement of major parts of the system architecture, e.g., the batteries, the keyboard and the trackpad
   e. Connect to the Main Display Chassis by means of a hinge or hinges
   f. Offer these benefits when configured as per the invention:
      i. Support a variety of device sizes and styles with a single Main Base Chassis, allowing interchangeable visible parts such as the C Cover, the D Cover and the keyboard to be attached to the Main Base Chassis in order to differentiate various device models
      ii. Provide for scalability of the Main Base Chassis to larger or smaller implementations of the same basic design, e.g. the use of the same fixation methods component placement locations reducing the risks associated electronic interference, and EMC, etc., reducing design and testing cycle time, design risk, and time to market. And facilitating the use of the same components between models)
      iii. Provide for reduction in logistical and assembly complexity, resulting in lower inventory cost/risk, lower conversion/assembly cost, and higher repeatability and, therefore, quality and reliability
2. Main Display Chassis/Display Front (See Figure 4. Figure 5 and Figure 6) - A (figuratively) flexible and scalable internal and/or external substructure or chassis that is common or similar among a plurality of device models, sizes and form factors. When the Main Display Chassis also forms all or part of the B Cover, it may also be referred to as the Main Display Front, as in Figure 4. The Main Display Chassis may.
   a. Provide rigidity to the computing device upper part and resist/absorb torsional or other forces, especially offering protection to the display panel
   b. Provide a frame on which other cosmetic or functional mechanical elements, e.g., the A Cover and B Cover, may be mounted. It may also incorporate some of those cosmetic or functional elements, such as serving as the B Cover and/or A cover, as mentioned above.
   c. Provide a frame on or into which electronic and electromechanical parts or components, e.g., display panel and camera, may be mounted and/or protected
   d. Determine the placement of major parts of the system architecture, e.g., the display panel
   e. Connect to the Main Base Chassis by means of a hinge or hinges
   f. Be included in some embodiments in the display assembly of a convertible computer display part. (See Figure 6)
   g. Offer these benefits when configured as per the invention:
      i. Support a variety of device sizes and styles with a single Main Display Chassis, allowing interchangeable visible parts such as the A Cover, the B Cover and the display to be attached to the Main Display Chassis in order to differentiate various device models
      ii. Provide for scalability of the Main Display Chassis to larger or smaller implementations of the same basic design, e.g., the same display mounting methods etc., reducing design and testing cycle time, design risk, and time to market
      iii. Provide for reduction in logistical and assembly complexity, resulting in lower inventory cost/risk, lower manufacturing conversion/assembly cost, and higher repeatability and, therefore, quality and reliability
3. Common/Similar Components (See component examples in Figure 2, Figure 3, Figure 4, Figure 5, Figure 10 and Figure 11) - Provision for common and/or similar major components and subsystems, such as batteries, keyboard engines, thermal solutions, input/output connectors, wireless modules, PCBs, fixed/removable storage devices, displays, antennas, cable assemblies, to be held within the various internal chassis, providing the following benefits:
   a. Reduction in logistical and assembly complexity, resulting in lower inventory cost/risk, lower conversion/assembly cost, and higher repeatability and, therefore, quality and reliability
   b. Scalability of the system architecture to larger or smaller implementations of the same basic design, e.g. the same cable routing methods and component fixation methods etc., reducing design and testing cycle time, design risk, and time to market
   c. Examples of common/similar component implementations include:
      i. Keyboards - A common keyboard engine could mate to specific keycaps, markings (perhaps applied during device manufacturing/assembly) and/or layouts to enable:
         1. Localized keyboards with a maximum of common components
         2. Different keyboard styles, e.g., typewriter or chiclet style keys
      ii. Batteries - A minimum number of scalable battery packs to cover many different device models and sizes
         1. Common battery cells which could be coupled together like building blocks to provide for different battery capacities
         2. Either cylindrical or prismatic battery cells to fit with different device thickness goals
         3. Common connector and "flippable" battery design that could enable the same battery pack design to be used in opposite orientation on opposite sides of the device, simultaneously providing increased battery capacity whilst reducing the number of battery types.
      iii. Thermal solution - Common thermal solution across many different sizes, models and processor configurations
      iv. Hinges - A standardized hinge type that could be adjustable in width and torque in order to accommodate various display sizes and weights
4. "Stack" and "Flush" Design Variations - In addition to enabling a very wide variety of styles and form factors, sizes, models, decorations and device type, the invention includes the provision for prioritising of either:
   a. Flush design - The thickness/depth/z-dimension (i.e., the measure between the top of the A Cover and the bottom of the D Cover of a closed clamshell), where the top of the A Cover is in plane with the top of the C Cover palmrests when the laptop is closed. In this way, sections of the C Cover, including the palmrest and outer side strips are visible around the edges of A Cover rather than being fully covered by the A Cover as in more traditional laptop designs.
      i. Removes the combined contribution of the battery and display part thickness to the overall device thickness by separating them into two different stacks
      ii. Allows for maximum battery thickness/capacity whilst achieving a very thin design. With currently typical alternative implementations, relatively thick/high capacity batteries are result in a relatively thick overall device.
      or
   b. Stack design - The length/y-dimension (i.e., the measure front the front to the back of the closed clamshell with the display in the usual landscape orientation), where the upper/display part of the laptop sits over the top of the C Cover and palmrests when the laptop is closed.
      i. Gives a more traditional appearance to the device, albeit at the expense of thickness compared to the Flush design
      ii. Allows for larger displays while maintaining the smallest possible y-dimension
   See Figure 7, Figure 8 and Figure 9. The same basic computing device base design could be used for either Flush or Stack design models.
5. Beneficial component/subassembly placement - Locations of the various major components or subsystems may be common or similar across the plurality of device models, sizes and form factors, offering substantial benefits in design simplification, quality, reliability, economies of scale, manufacturing and assembly. Major component placements are shown in Figure 2, Figure 3, Figure 4 and Figure 10. Components may be mounted directly to one of the chassis or covers, or they may be mounted by means of a set of carriers which attach to or contain the various components and which themselves are mounted to a chassis or cover, which the benefit of keeping the relatively larger and more costly chassis and covers common while the carriers might be specially adapted for particular components. Examples of component placement include:
   a. Batteries
      i. Placed under the palmrests to the left and right of the trackpad or other pointing device
      ii. Could be user replaceable with insertion from below, from the front, or from the sides
      iii. Could be cylindrical or prismatic
      iv. Could employ a "flippable" design enabling the same battery pack design to be used either on the right or the left with the device-side connectors in opposite orientation
      v. Area for battery capacity increases as display sizes grow.
      vi. Allows for a "hot swappable" configuration allowing the user to change one battery whist power is provided by the other.
      vii. In addition to flexibility in device design and capacity noted earlier, placement of the batteries has a number of other benefits:
         1. Placement at the front of the device acts as a counterweight to the display, encouraging stability when the clamshell is open.
         2. Having the same components in the same configuration under each palmrest promotes similar heat transfer through the palmrest, addressing consumer dissatisfaction issue with varied heat transfer from the two most contacted areas of the device. (Tests show that consumers are disturbed more by uneven heat transfer than by heat transfer itself.)
         3. As only the Z dimension of the battery is altered between batteries of different capacities, it allows the creation of extended battery packs that are common to all products, regardless of form factor. The increase in Z-dimension of the device increases both fan cooling efficiency and battery capacity disproportionately to x- and y- increases, thus this battery / power source mounting method harmonizes the two major constraints within a typical mobile computing device design.
   b. Thermal solution - Is typically one of the most design constrained and custom part of any electronic device. By creating a series of tested and common thermal solutions the design of the product is greatly simplified.
      i. Placed at the back of the device base with exhaust porting to the back or side
      ii. Could be a scalable by power class, e.g., 2-5W, 5-8W, 8-10W, 10-12W, 12-15W, 15-18W, 18-25W and 25-35W
      iii. Could allow for common placement of CPU, I/O blocks such as Northbridge and Southbridge, GPU and memory.
      iv. Could have a common exhaust scheme to allow predictable thermal performance across devices.
      v. This placement has a number of benefits:
         1. Hot air is directed away from the user in any of a laptop-, tablet-, or convertible-style form factor
         2. Scalability reduces design complexity, risk and time to market, and increases quality and economies of scale
   c. Speakers
      i. Speakers may be placed in the base
      ii. May be front- or side-firing
      iii. Design allows for substantial acoustic free space around speakers
      iv. The placement has a number of benefits:
         1. Speaker output may be directed toward the user
         2. Usable space for speaker and acoustic chambers is proportional to display size, supporting the consumer expectation for "better" sound as display sizes increase
         3. Placing the speakers in the front adjacent to the batteries moves the speakers which are susceptible to electromagnetic interference away for electronics which could cause such interference.

## Claims

1. A computing device comprising a clamshell design, comprising:
a main base chassis and a main display chassis for providing structural support and component placement positions; and
components mounted in defined positions;
wherein the main display chassis comprises:
a top surface of the clamshell when closed (A Cover); and
wherein the main base chassis comprises:
a bottom surface of the clamshell when closed (D cover); and
wherein the computing device further comprises:
a palmrest arranged in the main base chassis;
a display arranged in the main display chassis;
**characterized in that**:
the components are mounted in different positions predetermined by their system function;
the computing device further comprises one or more rechargeable batteries placed under the palmrest; and palmrest; and
wherein the top surface of the A cover closes behind and in plane with the top of the palmrest arranged in the main base chassis, thereby separating the one or more rechargeable batteries and the display into two different stacks;
wherein the palmrest comprises a left hand palmrest and a right hand palmrest and wherein the one or more rechargeable batteries comprise a first battery pack positioned under the left hand palmrest and another battery pack, identical in shape and dimensions to the first battery pack but inverted, positioned under the right hand palmrest.

2. The computing device according to claim 1, wherein some components are mounted together or individually in separate carriers, which are affixed to one of the chassis.

3. The computing device according to any preceding claim, wherein mechanical elements are directly affixed to one of the chassis.

4. The computing device according to any preceding claim, wherein the one or more rechargeable batteries are insertable from underneath the computing device.

## Patentansprüche

1. Computervorrichtung mit einem Clamshell-Design umfassend:
ein Hauptbasisgehäuse und ein Hauptanzeigegehäuse zur Bereitstellung struktureller Unterstützung und Komponentenplatzierungspositionen; und
Komponenten, die in definierten Positionen montiert sind;
wobei das Hauptanzeigegehäuse umfasst:
eine obere Fläche der Clamshell im geschlossenen Zustand (A-Abdeckung); und
wobei das Hauptbasisgehäuse umfasst:
eine untere Fläche der Clamshell im geschlossenen Zustand (D-Abdeckung); und
wobei die Computervorrichtung weiterhin umfasst:
eine Handballenablage, die im Hauptbasisgehäuse angeordnet ist;
eine Anzeige, die im Hauptbasisgehäuse angeordnet ist;
**dadurch gekennzeichnet, dass**
die Komponenten in unterschiedlichen Positionen, die durch ihre Systemfunktion vorbestimmt sind, moniert sind;
wobei die Computervorrichtung weiter eine oder
mehrere wiederaufladbare Batterien umfasst, die unter der Handballenablage angeordnet sind; und
wobei die obere Fläche der A-Abdeckung hinter und in Ebene mit der Oberseite der im Hauptbasisgehäuse angeordneten Handballenablage schließt, wodurch die eine oder die mehreren wiederaufladbaren Batterien und die Anzeige in zwei verschiedene Stapel unterteilt werden;
wobei die Handballenablage eine linke Handballenablage und eine rechte Handballenablage umfasst und wobei die eine oder die mehreren wiederaufladbaren Batterien einen ersten Batteriepack umfassen, der unter der linken Handballenablage angeordnet ist, und einen weiteren Batteriepack, der in Form und Abmessungen mit dem ersten Batteriepack identisch ist, jedoch umgekehrt, der unter der rechten Handballenablage angeordnet ist.

2. Computervorrichtung nach Anspruch 1, wobei einige Komponenten zusammen oder einzeln in separaten Trägern montiert sind, die direkt an eines der Gehäuse befestigt sind.

3. Computervorrichtung nach einem vorhergehenden Anspruch, wobei mechanische Elemente direkt an eines der Gehäuse befestigt sind.

4. Computervorrichtung nach einem vorhergehenden Anspruch, wobei die eine oder mehrere wiederaufladbaren Batterien
unterhalb der Computervorrichtung einsetzbar sind.

## Revendications

1. Un dispositif informatique avec un système à clapet, comprenant :
un châssis de base principal et un châssis d'afficheur principal destinés à assurer un support structurel et des positions de placement de composants ; et
des composants montés à des positions définies ;
dans lequel le châssis d'afficheur principal comprend :
une surface supérieure du clapet lorsque celui-ci est fermé (Couvercle A) ; et
dans lequel le châssis de base principal comprend :
une surface inférieure du clapet lorsque celui-ci est fermé (Couvercle D) ; et
dans lequel le dispositif informatique comprend en outre :
un repose-poignets agencé dans le châssis de base principal ;
un afficheur agencé dans le châssis d'afficheur principal ;
**caractérisé en ce que** :
les composants sont montés en des positions différentes prédéterminées par leur fonction dans le système ;
le dispositif informatique comprend en outre une ou plusieurs batteries rechargeables placés sous le repose-poignets ; et
dans lequel la surface supérieure du couvercle A se ferme derrière et au même niveau que le dessus du repose-poignets agencé dans le châssis de base principal, dissociant ainsi en deux empilements différents les une ou plusieurs batteries rechargeables de l'afficheur ;
dans lequel le repose-poignets comprend un repose-poignet pour la main gauche et un repose-poignet pour la main droite et dans lequel les une ou plusieurs batteries rechargeables comprennent un premier bloc de batterie positionné sous le repose-poignet pour la main gauche et un autre bloc de batterie, de forme et de dimensions identiques à celles du premier bloc de batterie mais inversées, positionné sous le repose-poignet pour la main droite.

2. Le dispositif informatique selon la revendication 1, dans lequel certains composants sont ensemble ou individuellement montés dans des supports distincts, qui sont solidarisés à l'un des châssis.

3. Le dispositif informatique selon l'une des revendications précédentes, dans lequel des éléments mécaniques sont solidarisés directement à l'un des châssis.

4. Le dispositif informatique selon l'une des revendications précédentes, dans lequel les une ou plusieurs batteries rechargeables peuvent être insérées par le dessous du dispositif informatique.
